# FASCICULE DE BREVET EUROPEEN

(11) **EP 2 575 987 B1**
(45) Date de publication et mention de la délivrance du brevet: **11.12.2019**
(21) Numéro de dépôt: 11705004.7
(22) Date de dépôt: 12.01.2011
(51) Int. Cl.: A63F 13/2145

(54) **ENSEMBLE INTERACTIF FIGURINE MATÉRIELLE / PLATEAU DE JEU ÉLECTRONIQUE MULTI JOUEUR À AUTHENTIFICATION AUTOMATIQUE DE FIGURINE**
INTERAKTIVE ANORDNUNG AUS MATERIALFIGUREN UND EINEM ELEKTRONISCHEN SPIELBRETT FÜR MEHRERE SPIELER MIT AUTOMATISCHER FIGURENAUTHENTIFIZIERUNG
MULTI-PLAYER MATERIAL FIGURINE/ELECTRONIC GAME PAD INTERACTIVE ASSEMBLY WITH AUTOMATIC FIGURINE AUTHENTICATION

(30) Priorité: 02.06.2010 FR 1002334; 30.07.2010 FR 1003200
(43) Date de publication de la demande: 10.04.2013
(73) Titulaire: Mineur, Jean Etienne, 87069 Limoges (FR); Duplat, Bertrand, 75012 Paris (FR)
(72) Inventeur: Mineur, Jean Etienne, 87069 Limoges (FR); Duplat, Bertrand, 75012 Paris (FR)
(74) Mandataire: Schwalek, Valérie
(86) Numéro de dépôt international: PCT/FR2011/000013
(87) Numéro de publication internationale: WO 2011/151531

(56) Documents cités:
- WO-A1-95/15057
- WO-A2-02/10791
- US-A- 5 088 928
- US-A1- 2004 248 650
- US-A1- 2007 062 852
- US-A1- 2008 144 978
- US-A1- 2009 315 258

## Description

La présente invention concerne une empreinte signature à maillage de picots reconnaissable sur écran capacitif. L'invention s'adapte notamment à un ensemble interactif figurine matérielle / plateau de jeu électronique pour jeu multi joueur. L'invention s'applique également dans des applications dites solo qui permettent de reconnaître automatiquement l'identité de l'utilisateur.

L'invention s'adapte également à une signature sur feuille papier, sur cartes à jouer ou sur emballage de produits.

L'invention s'adapte également pour être reconnue par des tapis souris d'ordinateurs qui sont connus en anglais sous la dénomination touch pad et qui sont des surfaces qui reconnaissent les mouvements des doigts et qui transcrivent des ordres à l'ordinateur visibles sur l'écran.

Il est connu différents couple de dispositifs interactifs figurine / plateau. Traditionnellement, pour les jeux de plateau il est connu des couples figurines matérielles / plateau matériel. Il est également connu des plateaux de jeux électroniques mais qui sont commandées par des manettes de jeu électronique.

Le document US 2007/062852 A1 décrit un ensemble comprenant un écran tactile capacitif et des figurines qui comportent une signature d'authentification reconnue par l'écran tactile. L'authentification n'est pas réalisée au moyen de l'électricité statique provenant du corps de l'utilisateur mais du fait de la différence de capacité que les figurines génèrent lorsqu'elles sont mises en contact avec l'écran.

Le document WO 95/15057 A1 décrit un dispositif permettant de transmettre des données via la lumière, à travers un écran cathodique.

Le document US 2009/315258 A1 décrit un ensemble interactif qui comprend un plateau de jeu, lequel comprend une pluralité de capteurs capacitifs et des figurines dont toute la base est électriquement conductrice.

Il n'est pas connu de plateau de jeu multi joueur qui soit commandé par des figurines matérielles évoluant sur le plateau de jeu électronique.

L'invention vise en fait à donner au plateau de jeu traditionnellement matériel, en carton ou feuille imprimée, de nouvelles fonctions en utilisant la technologie connue de l'écran tactile. L'invention s'adapte ainsi particulièrement bien aux nouveaux téléphones portables à écran tactile ou au tablette interactive.

Un objet principal de l'invention est de proposer un ensemble de jeu multi joueur qui utilise des figurines matérielles qui évoluent sur un plateau numérique électronique à technologie écran tactile. L'invention s'adapte également à un plateau de travail pour une personne, l'activation par la figurine identifiée d'un utilisateur déclenche sur le plateau l'interface spécifique de travail de la dite personne.

Un objet de l'invention est d'utiliser l'écran numérique pour faire varier les représentations de jeu en fonction de l'activation spécifique de chaque joueur identifié par sa figurine.

Un objet de l'invention est de coupler la reconnaissance matérielle de chaque figurine de joueur à une fonction spécifique du logiciel qui active spécifiquement le jeu en fonction de la figurine et de l'instruction donnée par la figurine.

Un objet de l'invention est de proposer également une version dégradée totalement numérique qui palie à l'absence éventuelle de figurine.

Un objet de l'invention est de proposer un dispositif de reconnaissance automatisé de chaque figurine sur l'écran tactile.

Un objet d'une variante de l'invention est de proposer des figurines matérielles qui soient des robots. Ces figurines robots peuvent être pilotées en recevant des instructions lumineuses depuis l'écran tactile.

Un objet de l'invention est de l'invention est de proposer un ensemble qui soit économique, facilement industrialisable et qui s'adapte aux dernières technologies de terminaux à écran tactile.

Un objet de l'invention est de pouvoir adapter facilement les jeux à plateau matériel traditionnels. L'invention demande simplement de développer un premier logiciel de reconnaissance et d'interactivité figurine / plateau, puis pour chaque plateau de jeu une infographie et son logiciel de gestion de règles de jeu.

Un objet de l'invention est de proposer une reconnaissance automatisée de figurine sur écran tactile.

La présente invention concerne un ensemble interactif figurine matérielle / plateau de jeu électronique pour jeu multi joueur, animé par un logiciel de jeu qui représente le plan de jeu plateau sur un écran tactile capacitif ; lesdites figurines comprenant une semelle comportant une signature d'authentification reconnue par l'écran tactile capacitif, la signature est réalisée dans une zone de signature par une grille d'authentification comportant un maillage conducteur de picots conducteurs reliés entre eux. De manière caractéristique, selon l'invention, les figurines sont conductrices, la signature est réalisée dans une zone de signature par une grille d'authentification comportant un maillage conducteur de picots conducteurs reliés entre eux, lesdits picots sont reliés entre eux par des fines connexions en encre conductrice, ladite zone de signature recouvre le verso d'une feuille de papier, le recto de la ladite feuille est collé sur ladite semelle, ledit écran capacitif comporte une grille de lecture qui analyse ladite signature et lesdites figurines comprennent des moyens conducteurs alimentant le maillage conducteur en électricité statique provenant du corps d'un utilisateur tenant la figurine, de sorte que chaque figurine est identifiable lorsqu'elle est déplacée par l'utilisateur sur la grille de lecture de l'écran tactile capacitif du plateau de jeu et que la zone de signature est appliquée contre l'écran tactile capacitif par l'utilisateur tenant la figurine.

Selon un mode de réalisation, lesdits picots ont des tailles différentes.

Selon un mode de réalisation, la figurine est un robot qui repose sur sa semelle qui est reconnue par la grille de l'écran, la figurine étant pilotée par la puce de commande du plateau qui commande l'émission de rayons lumineux par la couche émettrice de lumière du plateau, selon des caractéristiques spécifiques codées.

Un objet de l'invention est d'utiliser la figurine pour modifier la représentation numérique de la surface de jeu de plateau. En la déplaçant sur l'écran tactile, la figurine prend la fonction de manette et transmet sur la surface de l'écran une translation et / ou une rotation.

Un objet de l'invention est de proposer une signature personnalisée qui peut être facilement imprimée sur le recto ou sur le verso d'une feuille de papier ou sur le recto ou le verso d'un emballage. Dans cette fonction, la signature peut remplacer des outils tel le couple code barre / lecteur de code barre en le remplaçant par le couple signature à picots / écran tactile.

Dans un aspect, l'écran tactile est un écran à technologie dite capacitive.

Dans un aspect principal, l'invention propose des figurines conductrices qui ont une semelle à signature. Cette semelle à signature permet au logiciel de la plateforme électronique de jeu de reconnaître automatiquement en déplaçant le pion sur le jeu de quel pion il s'agit.

Dans un aspect, l'invention propose une figurine robotisée qui sait lire des instructions lumineuses et un plateau de jeu qui canalise des instructions lumineuses sous la semelle de la figurine. Ces instructions de jeu génèrent automatiquement des déplacements physiques de la figurine sur l'écran. Les déplacements physiques de la figurine peuvent générer également un défilement graphique de la surface de jeu sur l'écran.

Dans un aspect, l'invention propose de propose des semelles qui sont constituées par l'impression d'encre conductrice sur une feuille papier.

Dans un aspect, l'invention propose de propose des semelles qui sont constituées par l'impression de matériau conducteur d'électricité statique, mousse ou plastique ou matériau spécial, sur une feuille papier.

Les figures annexées représentent un mode particulier de l'invention sur lesquelles :
- La figure 1 représente un plateau de jeu électronique selon l'invention
- La figure 2 représente un plateau de jeu avec ses figurines selon l'invention
- Les figures 3a et 3b représentent plusieurs semelles de figurines
- La figure 4 représente une figurine automobile commandée par l'écran selon une variante de l'invention
- Les figures 5a et 5b représentent une variante de l'invention avec une zone de signature sur une feuille en recto verso
- La figure 6 représente une variante de zone de signature sur une avec un maillage relié de point à encre conductrice
- La figure 7 représente la lecture d'une feuille de la figure 6 sur un écran capacitif
- La figure 8 représente des moyens de mise en contact de la feuille sur l'écran capacitif

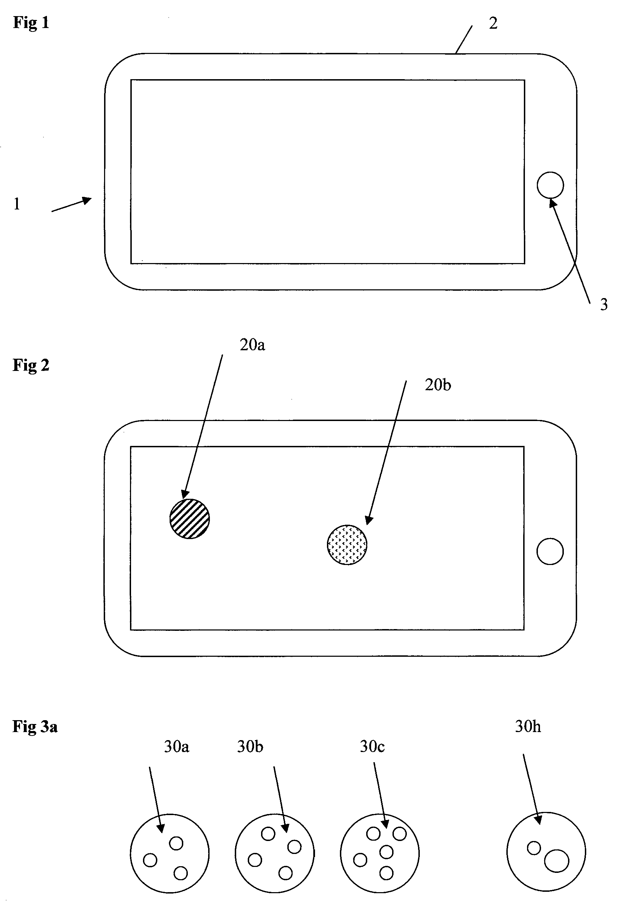

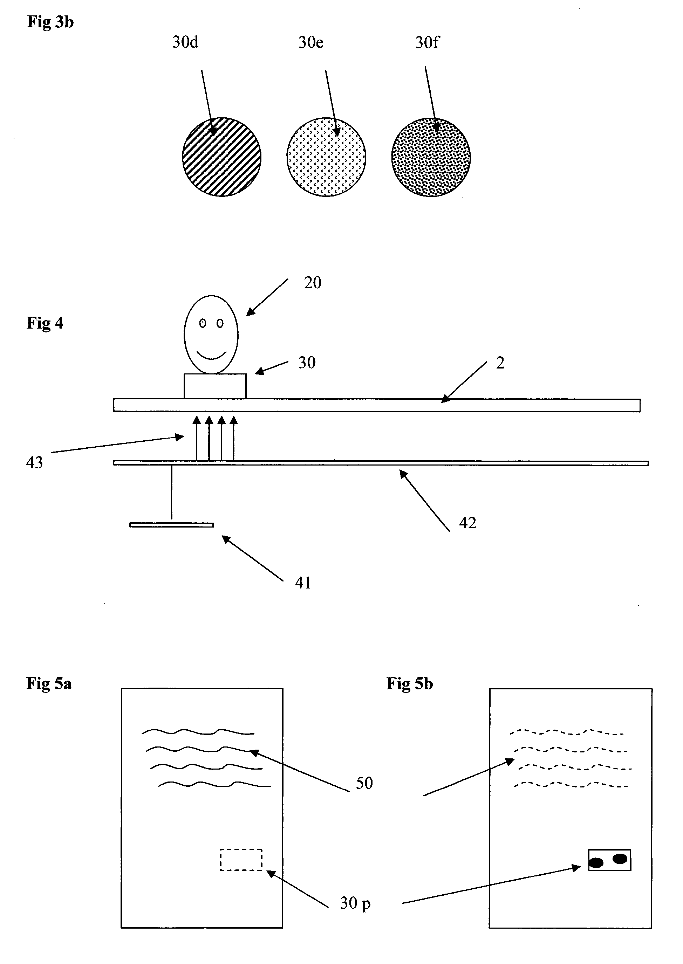

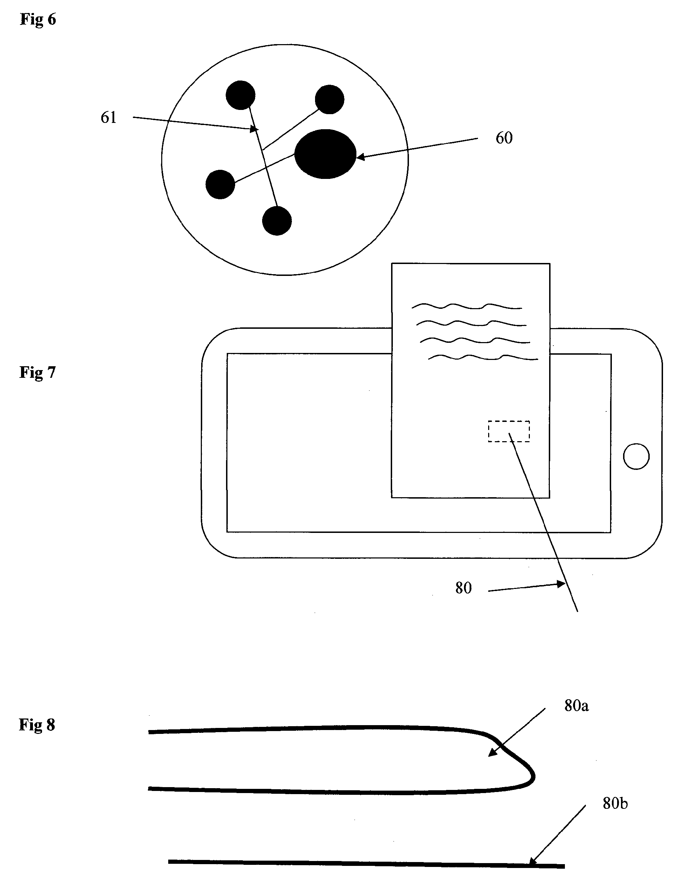

La figure 1 représente un plateau de jeu électronique (1) qui comprend un écran tactile (2) et une manette de commande manuelle (3) du plateau de jeu. Ce plateau de jeu est par exemple un téléphone portable de dernière génération ou une tablette électronique de dernière génération ou un ordinateur avec un tapis de souris piloté par les doigts. La figure 2 représente un plateau de jeu (1) avec deux figurines (20a, 20b) qui sont les figurines qui représentent le pion de chaque de deux joueurs qui sont en train de partager une partie. Les figures 3a et 3b représentent plusieurs semelles de figurines (30a, 30b, 30c, 30h, 30d, 30 e, 30f). Ces semelles comportent des picots (30a, 30b, 30c, 30h), des striures (30d), des qualités de grains (30e, 30f). Sous une certaine forme pour augmenter les capacités d'identification, les picots sont de tailles différentes, figure 30h En posant la figurine sur l'écran, ou en déplaçant la figurine sur l'écran, la figurine est reconnue par le logiciel du jeu de plateau. En effet, l'écran tactile comprend une grille qui analyse la grille de chaque semelle. Le logiciel affecte une identité de joueur à chaque semelle identifiée par la grille de lecture d'écran. Il est par exemple compris que la semelle peut comprendre, trois, quatre, cinq, six ou plus de picots. Il est également compris que la grille de semelle peut présenter un quadrillage particulier (rainures, grains) qui soit identifié par la grille de lecture de l'écran. Il est également entendu que la grille peut être plane et simplement matérialisé par une impression d'encre conductrice. La figure 4 représente une variante de l'invention avec une figurine (20) automobile qui est un petit robot qui repose sur sa semelle (30). Dans cette variante, la semelle est non seulement reconnue par la grille de l'écran mais est également pilotée par la puce de commande (41) du plateau qui commande, émis par la couche émettrice (42) de lumière du plateau, l'émission de rayons lumineux (43) selon des caractéristiques spécifiques codées. Ces rayons codées donnent des instructions à la figurine robotisée qui se déplace sur l'écran. Les figures 5a et 5b représentent une variante de l'invention avec une zone de signature sur une feuille en recto verso. Sur le recto de la feuille sont imprimées le texte et les motifs de lecture (50), sur le verso de la feuille est imprimée en encre conductrice la zone de signature (30p) telle que décrite en figure 6. Pour lire la signature, voir, figure 7, l'utilisateur plaque la zone de signature (30p) sur l'écran capacitif, en prenant bien soin d'utiliser les moyens de la figure 8, qui sont soit le doigt de l'utilisateur (80a), soit un stylet conducteur (80b), soit une figurine conductrice. Le but recherché est bien celui que l'écran capacitif puisse lire la zone de signature et soit donc alimenté en électricité statique provenant du corps de l'utilisateur. La figure 6 représente une variante de zone de signature sur une avec un maillage relié de point à encre conductrice. Cette figure reprend le principe des figures 3a, et 3b avec un maillage de picots avec l'amélioration qui est que cette fois ci les picots sont des points en encre conductrice (60). Les points de signature (60) sont maillés (61) et reliés entre eux par des fines connexions en encre conductrice de façon à ce que quand l'utilisateur appuie sur la zone de signature sans forcément appuyer sur tous les points, tous les points soient par contre tous alimentés en électricité statique. L'invention met en lumière une découverte qui n'était absolument pas évidente à priori qui est celle celui que le papier de la feuille transmet la conductivité. Si le verso d'une feuille est recouvert d'une zone de signature, l'utilisateur en appuyant avec des moyens conducteurs sur le recto pourra déclencher la lecture de la signature par l'écran capacitif. Les signaux sont bien conduits à travers l'épaisseur du papier. Il est bien sûr compris que la semelle de la figurine conductrice pourra également être recouverte d'une zone de signature réalisée par le collage d'une feuille de papier signée avec une zone de signature selon la figure 6. La transmission se fera par la prise de la figurine par la main de l'utilisateur qui viendra la poser l'écran capacitif. Il est également compris que le maillage conducteur de points peut se faire dans le corps de la figurine et que seul l'extrémité du maillage avec quelques points / picots apparaît sur la semelle plane de la figurine.

Il est donc compris que l'invention permet de reconnaître les figurines qui sont posées dessus. Elle permet également de faire suivre le déplacement matériel des figurines sur l'écran par le logiciel de jeu qui adapte en fonction l'interface graphique représentée sur l'écran. Elle permet enfin dans une fonction avancée de piloter la figurine en la déplaçant sur l'écran. Dans cette version avancée l'invention permet un dialogue entre un écran numérique et une figurine robotisée, l'interface graphique représentée sur l'écran tactile est fonction de ce dialogue entre l'écran tactile et la figurine robotisée.

La présente invention concerne donc une signature d'authentification reconnue par un écran capacitif caractérisée en ce que elle est réalisée par une zone imprimée en encre conductrice de points (60) maillés (61) entre eux caractérisé, la zone de signature est appliquée contre l'écran capacitif par des moyens conducteurs (80) par l'utilisateur sur l'écran capacitif.

La présente invention concerne un ensemble interactif figurine matérielle (20) / plateau de jeu électronique pour jeu multi joueur, animé par un logiciel de jeu qui représente le plan de jeu plateau sur un écran caractérisé en ce que les figurines évoluent sur un écran tactile (2), et comprennent une semelle avec une grille d'authentification identifiable en les déplaçant sur la grille de lecture de l'écran tactile du plateau.

La présente invention concerne un ensemble interactif figurine matérielle (20) / plateau de jeu électronique pour jeu multi joueur caractérisé en ce que la grille d'authentification est une grille à picot.

La présente invention concerne un ensemble interactif figurine matérielle (20) / plateau de jeu électronique pour jeu multi joueur caractérisé en ce que le nombre de picot sur la semelle de la figurine permet d'authentifier la figurine

La présente invention concerne un ensemble interactif figurine matérielle (20) / plateau de jeu électronique pour jeu multi joueur caractérisé en ce que la figurine (20) est un robot automobile qui repose sur sa semelle (30) qui est reconnue par la grille de l'écran mais est également pilotée par la puce de commande (41) du plateau qui commande, émis par la couche émettrice (42) de lumière du plateau, l'émission de rayons lumineux (43) selon des caractéristiques spécifiques codées.

On voit bien que de nombreuses variantes éventuellement susceptibles de se combiner peuvent ici être apportées sans jamais sortir du cadre de l'invention tel qu'il est défini ci-après.

## Revendications

1. Ensemble interactif figurine matérielle (20) / plateau de jeu électronique pour jeu multi joueur, animé par un logiciel de jeu qui représente le plan de jeu plateau sur un écran tactile capacitif; lesdites figurines comprenant une semelle comportant une signature d'authentification reconnue par l'écran tactile capacitif, la signature est réalisée dans une zone de signature par une grille d'authentification comportant un maillage (61) conducteur de picots (60) conducteurs reliés entre eux, **caractérisé en ce que** les figurines sont conductrices, **en ce que** la signature est réalisée dans une zone de signature par une grille d'authentification comportant un maillage (61) conducteur de picots (60) conducteurs reliés entre eux, lesdits picots sont reliés entre eux par des fines connexions en encre conductrice, **en ce que** ladite zone de signature recouvre le verso d'une feuille de papier, **en ce que** sur le recto de ladite feuille est collé sur ladite semelle, **en ce que** ledit écran capacitif comporte une grille de lecture qui analyse ladite signature et **en ce que** lesdites figurines comprennent des moyens conducteurs alimentant le maillage conducteur en électricité statique provenant du corps d'un utilisateur tenant la figurine, de sorte que chaque figurine est identifiable lorsqu'elle est déplacée par l'utilisateur sur la grille de lecture de l'écran tactile capacitif du plateau de jeu et que la zone de signature est appliquée contre l'écran tactile capacitif par l'utilisateur tenant la figurine.

2. Ensemble selon la revendication 1, **caractérisé en ce que** lesdits picots ont des tailles différentes.

3. Ensemble interactif figurine matérielle (20) / plateau de jeu électronique pour jeu multi joueur selon la revendication 1 **caractérisé en ce que** la figurine (20) est un robot qui repose sur sa semelle (30) qui est reconnue par la grille de l'écran, la figurine étant pilotée par la puce de commande (41) du plateau qui commande l'émission de rayons lumineux (43) par la couche émettrice (42) de lumière du plateau, selon des caractéristiques spécifiques codées.

## Patentansprüche

1. Interaktive Anordnung aus materieller Figur (20) / elektronischem Spielbrett für ein Spiel mit mehreren Spielern, das von einer Spielsoftware animiert wird, die den Brettspielplan auf einem kapazitiven Berührungsbildschirm darstellt; wobei die Figuren eine Sohle, die eine durch den kapazitiven Berührungsbildschirm erkannte Authentifizierungssignatur aufweist, umfasst, wobei die Signatur in einem Signaturbereich durch ein Authentifizierungsgitter erzeugt wird, das ein leitendes Netz (61) aus miteinander verbundenen leitenden Spitzen (60) aufweist, **dadurch gekennzeichnet, dass** die Figuren leitend sind, dass die Signatur in einem Signaturbereich durch ein Authentifizierungsgitter realisiert ist, das ein leitendes Netz (61) aus miteinander verbundenen, leitenden Spitzen (60) aufweist, wobei die Spitzen miteinander durch dünne Verbindungen aus leitfähiger Tinte verbunden sind, dass der Signaturbereich die Rückseite eines Papierblatts bedeckt, dass die Vorderseite des Blatts auf die Sohle aufgeklebt ist, dass der kapazitive Bildschirm ein Lesegitter aufweist, das die Signatur analysiert, und dass die Figuren leitende Mittel umfassen, die das leitende Netz mit statischer Elektrizität versorgen, die von dem Körper eines Benutzers kommt, der die Figur hält, so dass jede Figur identifizierbar ist, wenn sie vom Benutzer auf dem Lesegitter des kapazitiven Berührungsbildschirms des Spielbretts bewegt wird, und dass der Signaturbereich gegen den kapazitiven Berührungsbildschirm von dem Benutzer, der die Figur hält, angelegt wird.

2. Anordnung nach Anspruch 1, **dadurch gekennzeichnet, dass** die Spitzen unterschiedliche Größen aufweisen.

3. Interaktive Anordnung aus materieller Figur (20) / elektronischem Spielbrett für ein Spiel mit mehreren Spielern nach Anspruch 1, **dadurch gekennzeichnet, dass** die Figur (20) ein Roboter ist, der auf seiner Sohle (30) aufliegt, die von dem Bildschirmraster erkannt wird, wobei die Figur von dem Steuerchip (41) des Bretts geleitet wird, der die Emission von Lichtstrahlen (43) durch die lichtemittierende Schicht (42) des Bretts gemäß bestimmten codierten Eigenschaften steuert.

## Claims

1. Material figurine (20)/electronic game pad interactive assembly for multi-player gaming, run by a gaming software item which represents the game board on a capacitive touch screen; said figurines comprising a base including an authentication signature that is recognised by the capacitive touch screen, the signature is produced in a signature zone by an authentication grid including a conductive mesh (61) of conductive points (60) connected to one another, **characterised in that** the figurines are conductive, **in that** the signature is produced in a signature zone by an authentication grid including a conductive mesh (61) of conductive points (60) connected to one another, said points are connected to one another by thin conductive ink connections, **in that** said signature zone covers the reverse side of a sheet of paper, **in that** the front side of said sheet is bonded to said base, **in that** said capacitive screen includes a reading grid which analyses said signature and **in that** said figurines comprise conductive means powering the conductive mesh with static electricity originating from the body of a user holding the figurine, such that each figurine can be identified when moved by the user on the reading grid of the capacitive touch screen of the game pad and when the signature zone is applied against the capacitive touch screen by the user holding the figurine.

2. Assembly according to claim 1, **characterised in that** said points have different sizes.

3. Material figurine (20)/electronic game pad interactive assembly for multi-player gaming according to claim 1, **characterised in that** the figurine (20) is a robot that rests on the base (30) thereof which is recognised by the grid of the screen, the figurine being controlled by the control chip (41) of the board that controls the emission of light rays (43) by the light-emitting layer (42) of the board, according to specific encoded features.
